# EUROPEAN PATENT SPECIFICATION

(11) **EP 1 695 218 B1**
(45) Date of publication and mention of the grant of the patent: **19.03.2008**
(21) Application number: 04808380.2
(22) Date of filing: 10.12.2004
(51) Int. Cl.: G06F 11/10

(54) **CHECKSUM GENERATION APPARATUS AND METHOD THEREOF**
PRÜFSUMMEN-ERZEUGUNGSVORRICHTUNG UND VERFAHREN DAFÜR
APPAREIL GENERATEUR D'UN TOTAL DE CONTROLE ET PROCEDE CORRESPONDANT

(30) Priority: 16.12.2003 KR 2003091882
(43) Date of publication of application: 30.08.2006
(73) Proprietor: SAMSUNG ELECTRONICS CO., LTD., Suwon-si, Gyeonggi-Do 442-742 (KR)
(72) Inventor: CHOI, Hyun-Seok, Seoul 135-812 (KR)
(74) Representative: Brandon, Paul Laurence
(86) International application number: PCT/KR2004/003249
(87) International publication number: WO 2005/059751

(56) References cited:
- EP-A2- 0 752 654
- JP-A- 6 259 268
- US-A- 5 701 316
- US-A- 5 912 909
- US-A- 5 960 012
- US-A1- 5 701 316
- US-A1- 5 912 909

## Description

### Technical Field

The present invention relates to data processing, and more particularly, to a checksum generation apparatus and a method thereof used to determine whether data is transmitted and received without errors.

### Background Art

A checksum calculation is to count bit number in a transmission unit of data in order to determine whether received data has the same bit number as data transmitted by a transmitter. If a checksum calculated by a receiver matches a checksum transmitted by the transmitter, it is determined that the data is received without errors. Checksum calculation and determination are performed in a transmission control protocol (TCP) and a user datagram protocol (UDP) of internet protocols.

The checksum calculation is one of the most important data processing in the internet protocols. In addition, it is necessary to calculate the checksum at a high speed. A conventional checksum calculation method has a problem that its calculation speed is too low since its adder processes data in units of 16 bits.

US 5,912,909 discloses an apparatus and method for calculating a checksum including a plurality of addition circuits forming at least a first and a final addition stage. The addition circuits receive a data bit stream and perform addition on data bit pairs emanating from the data bit stream to obtain a checksum value. Carry bits generated by the addition circuits are propagated as additional upper data bits until the final addition stage wherein the carry bits are added to lower bits to obtain a final checksum value.

EP 0 752 654 discloses a circuit and method for generating a checksum for a TCP packet on the fly. A stream of 32-bit data words from a TCP packet is split into two 16-bit data word streams and separately summed using 16-bit adders. The carry-out from the adders is tied to the carry-in thereof so as to incorporate any carry bits generated into the sum. At the end of the data stream, three further summing cycles are used in order to generate the final 16-bit one's complement checksum. First, the two 16-bit data stream partial sums are added together, including any carry bit from one of the adders while the carry-out from the other adder is stored. In the second cycle the stored carry-out and the carry-out from the first cycle are added into the sum. In the third cycle, any carry bit generated in the second cycle is added to the sum so as to produce the final checksum.

US 5,701 316 discloses an Internet checksum for use by TCP/IP is generated in a single macro-instruction called a Block Add Octets instruction.

### Disclosure of Invention

### Technical Solution

The present invention provides a checksum generation apparatus and a method thereof capable of improving a checksum calculation speed by performing an addition in units of 32 bits or more and converting an addition result to a 16-bit checksum.

### Advantageous Effects

According to the present invention, it is possible to increase a checksum calculation speed by not dividing input data. In particular, when the checksum generation apparatus is implemented in an ASIC device, it is possible to increase a calculation speed of a checksum generation apparatus by using 32-bit or 64-bit adder in a library of the ASIC device.

### Description of Drawings

FIG. 1 is a view for explaining a method of generating a checksum;

FIG. 2 is a block diagram illustrating a checksum generation apparatus according to an embodiment of the present invention;

FIG. 3 is a detailed block diagram illustrating a checksum generation apparatus using a 32-bitadder ;

FIG. 4 is a detailed block diagram illustrating a checksum generation apparatus using a 64-bit adder ;

FIG. 5A is a view illustrating a TCP segment format;

FIG. 5B is a view illustrating a pseudo header format; and

FIG. 6 is a flowchart illustrating a method of generating a checksum according to an embodiment of the present invention.

### Best Mode

According to a first aspect of the present invention, as defined in the appended claim 1, there is provided a checksum generation apparatus comprising: a control unit which, in response to information on a predetermined length,
outputs a control signal when an amount of data corresponding to the pre-determined length is received;
an addition unit which receives data, performs an addition on the received data to produce a first addition result comprising the first sum and the first carry, and in response to the control signal outputs a first sum and a first carry from the first addition result; and
a conversion unit which converts the first sum and the first carry into the checksum by adding the first sum to the first carry.

According to a second aspect of the present invention, as defined in the appended claim 11, there is provided a method of generating a checksum, the method comprising the steps:
(a) adding input data until a predetermined control signal is received, the control signal is output in response to an amount of data corresponding to a predetermined length being received;
(b) outputting a first sum and a first carry obtained from the first addition result, resulting from step (a), when the control signal is received; and
(c) adding the first sum and the first carry from the first addition result to convert the first addition result to a checksum.

According to a third aspect of the present invention, as defined in the appended claim 22, there is provided a computer-readable storage medium where a program executed by a computer is stored, the program comprising the method according to the second aspect.

### Mode for Invention

The present invention and operational advantages thereof can be fully understood by referring to the accompanying drawings and explanations thereof.

Now, exemplary embodiments of the present invention will be described with reference to the accompanying drawings to explain the present invention in detail. In the drawings, the same reference numerals indicate the same elements.

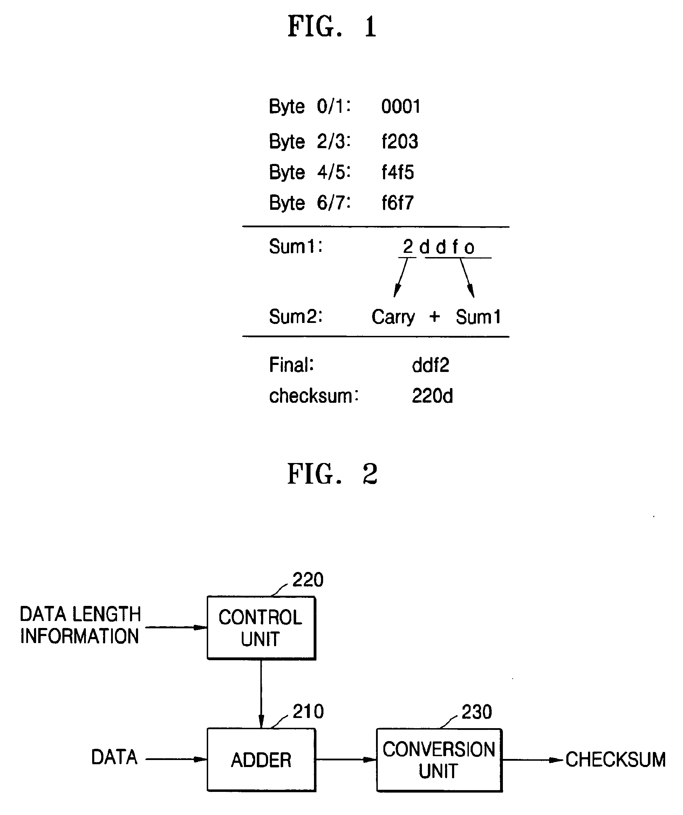

FIG. 1 is a view for explaining a method of generating a checksum.

A 16-bit adder is used for the method of generating the checksum. Firstly, data (0001 f203 f4f5 f6f7) is divided into 16-bit data segments and a first addition is performed on the 16-bit data segments. That is, the first addition is 0001 + f203 + f4f5 + f6f7. The first addition value Sum1 is 2dff0. Since the 16-bit adder is used, a carry of the first addition value Sum 1 is 2. In a second addition, the carry of the first addition value Sum1 is added back to the 16-bit adder to obtain a second addition value Sum2, that is, a final value: 2 + ddf0 = ddf2. The checksum is obtained by performing a 1's complement operation on the final value ddf2. Therefore, the checksum is 220d. The checksum calculation is disclosed in the RFC1071 document in detail.

FIG. 2 is a block diagram illustrating a checksum generation apparatus according to an embodiment of the present invention.

A checksum generation apparatus comprises an addition unit 210, a control unit 220, and a conversion unit 230. Data in units of a 32-bit or 64-bit segment is input to the addition unit 210. In some cases, the data may be input in units of more than 64-bit segment. The addition unit 210 may be constructed with a 32-bit or 64-bit adder. Moreover, the addition unit 210 may be constructed with an 80-bit, 96-bit, or 128-bitadder. In the present invention, the input data is not divided into 16-bit data segments but added as it is. In response to information on a predetermined input data length, the control unit 220 determines whether the input data corresponding to the input data length is received and accumulated. When the input data corresponding to the length is received the control unit 220 outputs a control signal to the addition unit 210. In response to the control signal, the addition unit 210 outputs its addition value to the conversion unit 230. The conversion unit 230 converts the addition value to a 16-bit checksum and outputs the checksum.

The addition unit 210 accumulates and adds the input data to obtain a partial sum until the control signal is received from the control unit 220. A carry addition is separately performed. In consideration of a maximum value of the carry, a result of the carry addition, that is, a carry sum, is stored in units of 10 bits. When the control signal is received from the control unit 220, the partial and carry sums are output to the conversion unit 230. The conversion unit 230 divides the partial sum in 16-bit segments and adds the 16-bit segments. The result of the addition is added back to the carry sum to obtain the final sum. The conversion unit 230 output a 1's complement value of the final sum. For example, assuming that the addition unit 210 performs the addition in units of 32 bits and the partial sum is a 32-bit value, the conversion units 230 obtains the final sum by; ding higher 16 bits and lower 16 bits of the 32-bit partial sum to the carry. In addition, assuming that the addition unit 210 performs the addition in units of 64 bits and the partial sum is a 64-bit value, the conversion units 230 obtains the final sum by; ding most significant 16 bits, higher 16 bits, and lower 16 bits, and least significant 16 bit of the 64-bit partial sum to the carry.

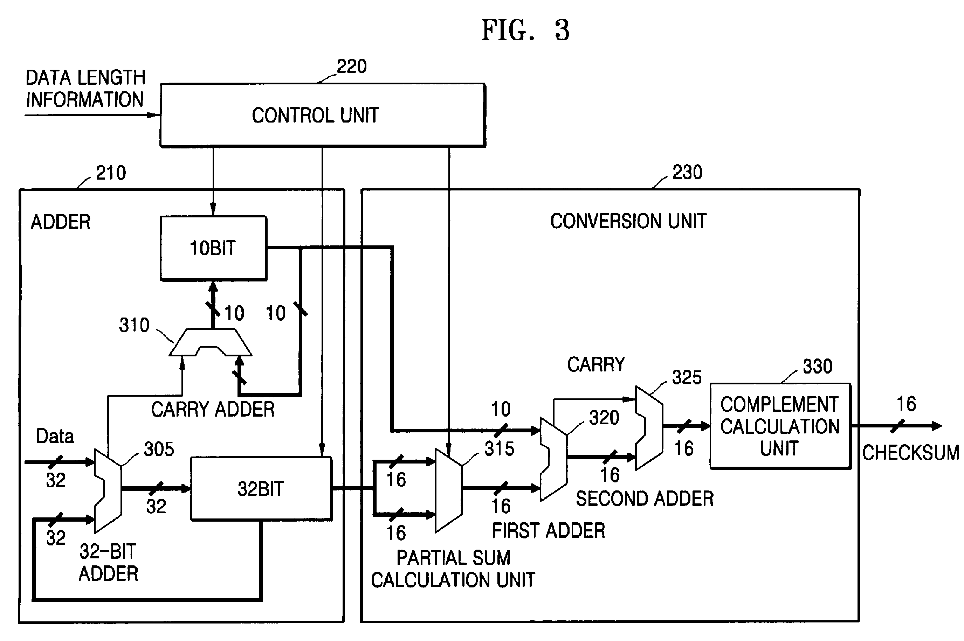

FIG. 3 is a detailed block diagram illustrating a checksum generation apparatus using a 32-bit adder.

An addition unit 210 comprises a 32-bit adder 305 and a carry adder 310. The 32-bit adder 305 adds input data, and the carry adder 310 adds carries. The conversion unit 230 comprises a partition adder 315, a first adder 320, and a second adder 325, and a complement calculator 330. The partition adder 315 partitions 32-bit data into high 16-bit data segment and low 16-bit data segment and adds the 16-bit data segments. The addition result is added back to a carry output from the carry adder in the first adder 320. The second adder adds an addition result of the first adder 320 310 to the carries and outputs a final sum, which has a 16 bit value. The complement calculator 330 outputs a 1's complement value of the final sum.

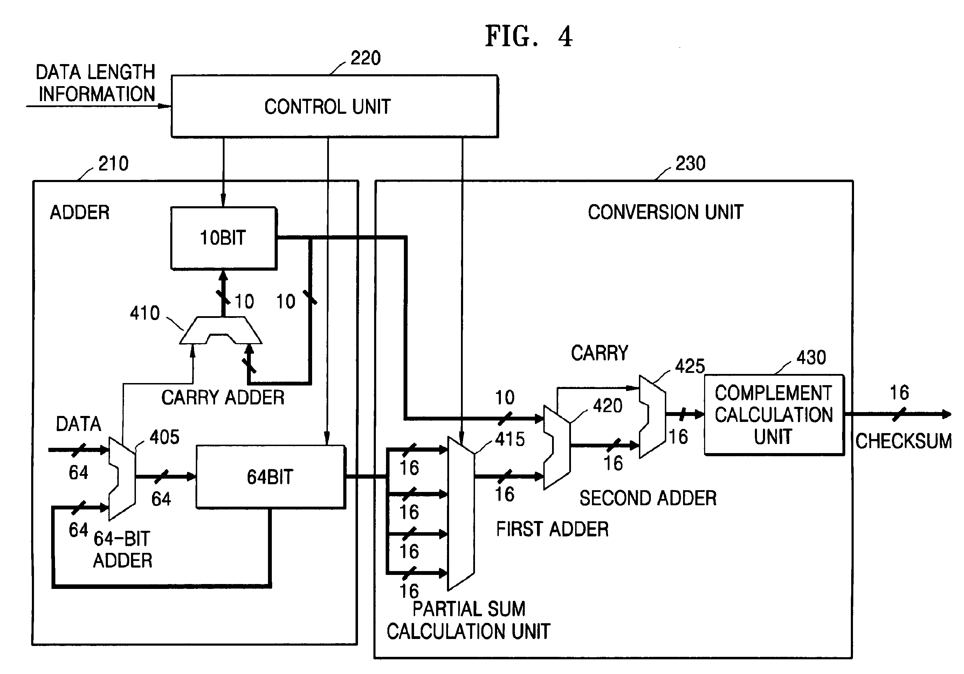

FIG. 4 is a detailed block diagram illustrating a checksum generation apparatus using a 64-bit adder.

An addition 210 comprises a 64-bit adder 405 and a carry adder 410. The 32-bit adder 405 adds input data, and the carry adder 410 adds carries. The conversion unit 230 comprises a partition adder 415, a first adder 420, and a second adder 425, and a complement calculator 430. The partition adder 415 partitions 62-bit data into four 16-bit data segments and adds the four 16-bit data segments. The other components are the same as the 32-bit adder.

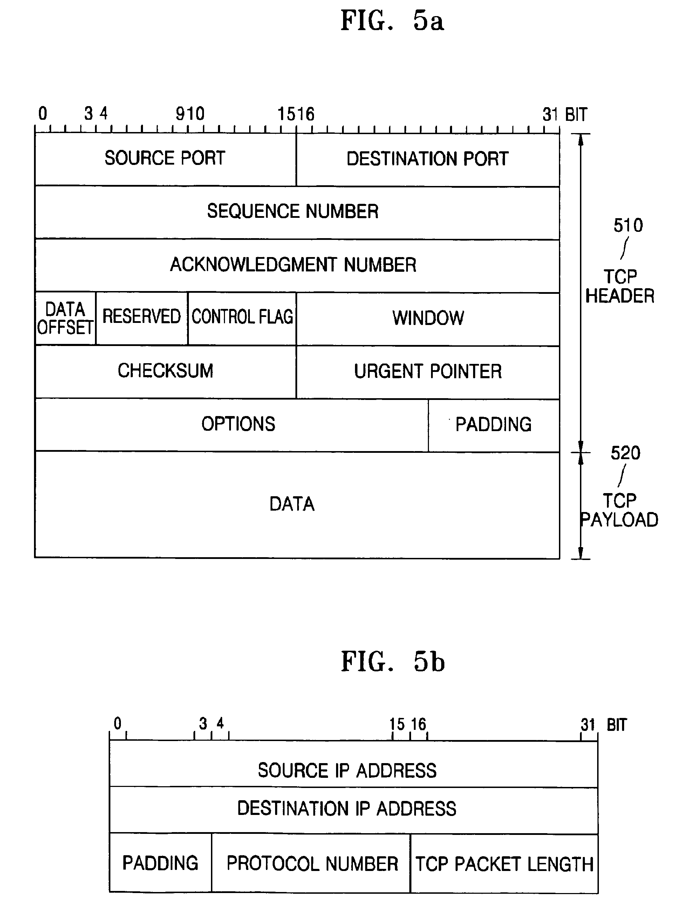

The checksum calculation described above can be employed to any protocols such as protocols IP, TCP, and UDP. Now, a checksum calculation employed in the protocol TCP will be described in detail with reference to FIGS. 5A and 5B.

FIG. 5A is a view illustrating a TCP segment format.

The TCP segment has a TCP header 510 and a TCP payload 520. The TCP header 510 has a checksum field where a checksum is entered. A pseudo header is needed in order to calculate the checksum in a protocol TCP. Other fields in the TCP segment are well known to the skilled, so their detailed descriptions are omitted.

FIG. 5B is a view illustrating a pseudo header format.

A pseudo header comprises a source IP address, a destination IP address, padding, a protocol number, a TCP packet length. The pseudo header is not really transmitted but used to calculate a checksum of a TCP packet. End portion of data has a value of 0 by a padding operation in order that the data length is a multiple of 16 bits. A checksum field of the TCP header has a value of 1. An addition is performed in units of 16 bits. A1's complement of the addition result is entered into the checksum field. When receiving TCP segments, the receiver obtains an IP address from an IP header, produces a TCP pseudo header, and calculates a checksum.

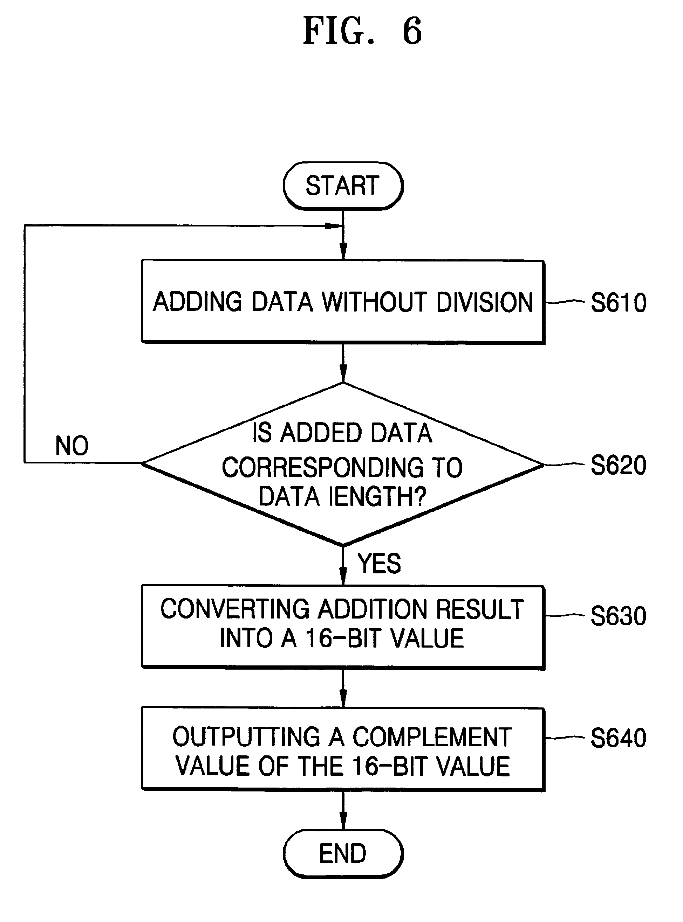

FIG. 6 is a flowchart illustrating a method of generating a checksum according to an embodiment of the present invention.

The input data is not divided into 16-bit data segments but added as it is (S610). Carries occurring in addition results are separately added together. The addition result of the carries is stored in units of 10 bits in consideration of a maximum value of the carries. It is determined whether the input data corresponding to the input data length is received and accumulated (S620). Until the input data corresponding to the length is received the input data is added. The addition result is converted to a 16-bit value (S630). A1's complement of the 16-bit value is output (S640).

Now, the step S630 in a case where the input data has a 16-bit value will be described in detail. The addition result and its carry are indicated by Sum1 and Carry1, respectively. Therefore, Temp1 = (16-bit MSB of Sum1) + (16-bit LSB of Sum1) + Carry1. If a carry of Temp1 is indicated by Carry2, Temp2 = (Temp1) + (Carry2). The value Temp1 becomes a 16-bit final value. In a case where the input data has a 64-bit value, the value Temp1 is obtained by adding four 16-bit segments and a carry. The value Temp2 is obtained by the same calculation as described above.

The above described method of generating a checksum can be implemented with a program. Codes and code segments constituting the program can be easily deduced by the skilled in the art. In addition, the program is stored in a computer-readable storage medium. The program is read and executed by a computer. The computer-readable storage medium includes a magnetic storage medium, an optical storage medium, and a carrier wave medium.

## Claims

1. A checksum generation apparatus, comprising:
a control unit (220) which, in response to information on a predetermined length, outputs a control signal when an amount of data corresponding to the pre-determined length is received;
an addition unit (210) which receives data, performs an addition on the received data to produce a first addition result comprising a first sum and a first carry, and, in response to the control signal, outputs said first sum and said first carry from said first addition result; and
a conversion unit (230) which converts the first sum and the first carry into a checksum by adding the first sum to the first carry.

2. The checksum generation apparatus according to claim 1, wherein the checksum has a value of 16 bits.

3. The checksum generation apparatus according to claim 1, wherein the addition unit (210) receives data in units of 32 bits and performs an addition on the received data.

4. The checksum generation apparatus according to claim 1, wherein the addition unit (210) receives data in units of 32 bits plus multiple of 16 bits and performs an addition on the received data.

5. The checksum generation apparatus according to claim 1, wherein the conversion unit (230) divides the first addition result into the first sum and the first carry, partitions the first sum into 16-bits segments, and adds the 16-bit segments to the first carry, thereby obtaining a second addition result.

6. The checksum generation apparatus according to claim 5, wherein, when a second carry occurs in the second addition result, the conversion unit excludes the second carry from the second addition result to produce a second sum and adds the second carry to the second sum, thereby outputting a second addition result.

7. The checksum generation apparatus according to claim 6, wherein the conversion unit (230) outputs a 1's complement value of the third addition result to obtain a 16-bit checksum.

8. The checksum generation apparatus according to claim 1, wherein the addition unit (210) comprises:
an adder (305) for adding the received data in units of 32 bits; and
a carry adder (310) for adding carries generated in the adder (305).

9. The checksum generation apparatus according to claim 1, wherein the addition unit (210) comprises:
an adder (305) for adding the received data in units of 32 bits plus multiple of 16 bits; and
a carry adder (310) for adding carries generated in the adder (305).

10. The checksum generation apparatus according to claim 1, wherein the conversion unit (230) comprises:
a partial sum addition unit (315) for excluding the first carry from the first addition result to form a first sum, partitioning the first sum into 16-bit segments, adding the 16-bit segments, thereby obtaining a partial addition result comprising a partial sum;
a first adder (320) for adding the first carry to the partial sum to produce a second addition result comprising a second sum and a second carry; a second adder (325) for adding the second sum and the second carry forming a third addition result; and
a complement calculator (330) for outputting a 1's complement value of the third addition result.

11. A method of generating a checksum, the method comprising the steps of:
(a) adding input data until a predetermined control signal is received to produce a first addition result comprising a first sum and a first carry, the control signal is output in response to an amount of data corresponding to a predetermined length being received;
(b) outputting said first sum and said first carry obtained from said first addition result, resulting from step (a), when the control signal is received; and
(c) adding said first sum and said first carry from said first addition result to convert said first addition result to a checksum.

12. The method of generating a checksum according to claim 11, wherein the checksum has a value of 16 bits.

13. The method of generating a checksum according to claim 11, wherein the control signal is output when an amount of data corresponding to input data length information is received.

14. The method of generating a checksum according to claim 11, wherein, in the step (a), data is received in units of 32 bits and an addition is performed on the received data.

15. The method of generating a checksum according to claim 11, wherein, in the step (a), data is received in units of 32 bits plus multiple of 16 bits and an addition is performed on the received data.

16. The method of generating a checksum according to claim 11, wherein, in the step (c), the first addition result is divided into the first sum and the first carry, the first sum is partitioned into 16-bit segments, and the 16-bit segments are added to the first carry, thereby a second addition result being obtained.

17. The method of generating a checksum according to claim 16, wherein, when a second carry occurs in the second addition result, in the step (c), the second carry is excluded from the second addition result to form a second sum, and then the second carry is added to the second sum, thereby a third addition result being output.

18. The method of generating a checksum according to claim 17, wherein, in the step (c), a 1's complement value of the third addition result is output as a 16-bit checksum.

19. The method of generating a checksum according to claim 11, wherein the step (b) further comprises the steps of:
(b1) adding the received data in units of 32 bits; and
(b2) adding carries generated in the step (b1).

20. The method of generating a checksum according to claim 11, wherein the step (b) further comprises the steps of:
(b1) adding the received data in units of 32 bits plus multiple of 16 bits; and
(b2) adding carries generated in the step (b1).

21. The method of generating a checksum according to claim 11, wherein the step (c) further comprises the steps of:
(c1) excluding a first carry from the first addition results forming the first sum, partitioning the first sum into 16-bit segments, adding the 16-bit segments, thereby obtaining a partial addition result comprising a partial sum;
(c2) adding the first carry to the partial sum, thereby producing a second addition result comprising a second sum and a second carry;
(c3) adding the second sum of the step (c2) and the second carry occurring in the second addition result, thereby producing a third addition result; and
(c4) outputting a 1's complement value of the third addition result of the step (c3).

22. A computer-readable storage medium storing computer-executable instructions whereby said instructions, when executed on a computer, performs a method of generating a checksum, wherein the method comprises the steps of:
(a) adding input data until a predetermined control signal is received to produce a first addition result comprising a first sum and a first carry, the control signal output in response to an amount of data corresponding to a predetermined length being received;
(b) outputting said first sum and said first carry obtained from said first addition result when the control signal is received; and
(c) adding said first sum and said first carry from the addition result to convert said first addition result to a checksum.

## Patentansprüche

1. Vorrichtung zum Erzeugen einer Prüfsumme, die umfasst:
eine Steuereinheit (220), die in Reaktion auf Informationen über eine vorgegebene Länge ein Steuersignal ausgibt, wenn eine Menge an Daten, die der vorgegebenen Länge entspricht, empfangen wird;
eine Additionseinheit (210), die Daten empfängt, eine Addition der empfangenen Daten durchführt, um ein erstes Additionsergebnis zu erzeugen, das eine erste Summe und einen ersten Übertrag umfasst, und in Reaktion auf das Steuersignal die erste Summe und den ersten Übertrag aus dem ersten Additionsergebnis ausgibt; und
eine Umwandlungseinheit (230), die die erste Summe und den ersten Übertrag in eine Prüfsumme umwandelt, indem sie die erste Summe zu dem ersten Übertrag addiert.

2. Vorrichtung zum Erzeugen einer Prüfsumme nach Anspruch 1, wobei die Prüfsumme einen Wert von 16 Bits hat.

3. Vorrichtung zum Erzeugen einer Prüfsumme nach Anspruch 1, wobei die Additionseinheit (210) Daten in Einheiten von 32 Bits empfängt und eine Addition der empfangenen Daten durchführt.

4. Vorrichtung zum Erzeugen einer Prüfsumme nach Anspruch 1, wobei die Additionseinheit (210) Daten in Einheiten von 32 Bits plus Vielfachen von 16 Bits empfängt und eine Addition der empfangenen Daten durchführt.

5. Vorrichtung zum Erzeugen einer Prüfsumme nach Anspruch 1, wobei die Umwandlungseinheit (230) das erste Additionsergebnis in die erste Summe und den ersten Übertrag teilt, die erste Summe in 16-Bit-Segmente unterteilt und die 16-Bit-Segmente zu dem ersten Übertrag addiert, um so ein zweites Additionsergebnis zu ermitteln.

6. Vorrichtung zum Erzeugen einer Prüfsumme nach Anspruch 5, wobei, wenn ein zweiter Übertrag in dem zweiten Additionsergebnis auftritt, die Umwandlungseinheit den zweiten Übertrag aus dem zweiten Additionsergebnis ausschließt, um eine zweite Summe zu erzeugen, und den zweiten Übertrag zu der zweiten Summe addiert, um so ein zweites Additionsergebnis auszugeben.

7. Vorrichtung zum Erzeugen einer Prüfsumme nach Anspruch 6, wobei die Umwandlungseinheit (230) einen 1-Komplementwert des dritten Additionsergebnisses ausgibt, um eine 16-Bit-Prüfsumme zu ermitteln.

8. Vorrichtung zum Erzeugen einer Prüfsumme nach Anspruch 1, wobei die Additionseinheit (210) umfasst:
eine Addiereinrichtung (305), die die empfangenen Daten in Einheiten von 32 Bits addiert; und
eine Übertrag-Addiereinrichtung (310), die in der Addiereinrichtung (305) erzeugte Überträge addiert.

9. Vorrichtung zum Erzeugen von Prüfsummen nach Anspruch 1, wobei die Additionseinheit (210) umfasst:
eine Addiereinrichtung (305), die die empfangenen Daten in Einheiten von 32 Bit plus Mehrfachen von 16 Bits addiert; und
eine Übertrag-Addiereinrichtung (310), die in der Addiereinrichtung (305) erzeugte Überträge addiert.

10. Vorrichtung zum Erzeugen einer Prüfsumme nach Anspruch 1, wobei die Umwandlungseinheit (230) umfasst:
eine Teilsummen-Additionseinheit (315), die den ersten Übertrag aus dem ersten Additionsergebnis ausschließt, um eine erste Summe zu erzeugen, die erste Summe in 16-Bit-Segmente unterteilt und die 16-Bit-Segmente addiert, um so ein Teilsummen-Additionsergebnis zu ermitteln, das eine Teilsumme umfasst;
eine erste Addiereinrichtung (320), die den ersten Übertrag zu der Teilsumme addiert, um ein zweites Additionsergebnis zu erzeugen, das eine zweite Summe und einen zweiten Übertrag umfasst;
eine zweite Addiereinrichtung (325), die die zweite Summe und den zweiten Übertrag addiert und ein drittes Additionsergebnis ausbildet; und
eine Komplement-Berechnungseinrichtung (330), die einen 1-Komplementwert des dritten Additionsergebnisses ausgibt.

11. Verfahren zum Erzeugen einer Prüfsumme, wobei das Verfahren die folgenden Schritte umfasst:
a) Addieren von Eingabedaten, um ein erstes Additionsergebnis zu erzeugen, das eine erste Summe und einen ersten Übertrag umfasst, bis ein vorgegebenes Steuersignal empfangen wird, wobei das Steuersignal in Reaktion darauf ausgegeben wird, dass eine Menge an Daten empfangen wird, die einer vorgegebenen Länge entspricht;
b) Ausgeben der ersten Summe und des ersten Übertrags, die aus dem ersten Additionsergebnis ermittelt werden, das aus Schritt a) resultiert, wenn das Steuersignal empfangen wird; und
c) Addieren der ersten Summe und des ersten Übertrags aus dem ersten Additionsergebnis, um das erste Additionsergebnis in eine Prüfsumme umzuwandeln.

12. Verfahren zum Erzeugen einer Prüfsumme nach Anspruch 11, wobei die Prüfsumme einen Wert von 16 Bits hat.

13. Verfahren zum Erzeugen einer Prüfsumme nach Anspruch 11, wobei das Steuersignal ausgegeben wird, wenn eine Menge an Daten empfangen wird, die Eingabedaten-Längeninformationen entspricht.

14. Verfahren zum Erzeugen einer Prüfsumme nach Anspruch 11, wobei in dem Schritt a) Daten in Einheiten von 32 Bits empfangen werden und eine Addition der empfangenen Daten durchgeführt wird.

15. Verfahren zum Erzeugen einer Prüfsumme nach Anspruch 11, wobei in dem Schritt a) Daten in Einheiten von 32 Bits plus Mehrfachen von 16 Bits empfangen werden und eine Addition der empfangenen Daten durchgeführt wird.

16. Verfahren zum Erzeugen einer Prüfsumme nach Anspruch 11, wobei in dem Schritt c) das erste Additionsergebnis in die erste Summe und den ersten Übertrag geteilt wird, die erste Summe in 16-Bit-Segmente unterteilt wird und die 16-Bit-Segmente zu dem ersten Übertrag addiert werden, so dass ein zweites Additionsergebnis ermittelt wird.

17. Verfahren zum Erzeugen einer Prüfsumme nach Anspruch 16, wobei, wenn ein zweiter Übertrag in dem zweiten Additionsergebnis auftritt, in dem Schritt c) der zweite Übertrag aus dem zweiten Additionsergebnis ausgeschlossen wird, um eine zweite Summe auszubilden, und dann der zweite Übertrag zu der zweiten Summe addiert wird, so dass ein drittes Additionsergebnis ausgegeben wird.

18. Verfahren zum Erzeugen einer Prüfsumme nach Anspruch 17, wobei in dem Schritt c) ein 1-Komplementwert des dritten Additionsergebnisses als eine 16-Bit-Prüfsumme ausgegeben wird.

19. Verfahren zum Erzeugen einer Prüfsumme nach Anspruch 11, wobei der Schritt b) des Weiteren die folgenden Schritte umfasst:
b1) Addieren der empfangenen Daten in Einheiten von 32 Bits; und
b2) Addieren in dem Schritt b1) erzeugter Überträge.

20. Verfahren zum Erzeugen einer Prüfsumme nach Anspruch 11, wobei der Schritt b) des Weiteren die folgenden Schritte umfasst:
b1) Addieren der empfangenen Daten in Einheiten von 32 Bits plus Mehrfachen von 16 Bits; und
b2) Addieren in dem Schritt b1) erzeugter Überträge.

21. Verfahren zum Erzeugen einer Prüfsumme nach Anspruch 11, wobei der Schritt c) des Weiteren die folgenden Schritte umfasst:
c1) Ausschließen eines ersten Übertrags aus den ersten Additionsergebnissen, um die erste Summe auszubilden, Unterteilen der ersten Summe in 16-Bit-Segmente, Addieren der 16-Bit-Segemente, um so ein Teiladditionsergebnis zu ermitteln, das eine Teilsumme umfasst;
c2) Addieren des ersten Übertrags zu der Teilsumme, um so ein zweites Additionsergebnis zu erzeugen, das eine zweite Summe und einen zweiten Übertrag umfasst;
c3) Addieren der zweiten Summe des Schritts c2) und des zweiten Übertrags, der in dem zweiten Additionsergebnis auftritt, um so ein drittes Additionsergebnis zu erzeugen; und
c4) Ausgeben eines 1-Komplementwertes des dritten Additionsergebnisses des Schritts c3).

22. Computerlesbares Speichermedium, das durch Computer ausführbare Befehle speichert, wobei die Befehle, wenn sie auf einem Computer ausgeführt werden, ein Verfahren zum Erzeugen einer Prüfsumme durchführen und das Verfahren die folgenden Schritte umfasst:
a) Addieren von Eingabedaten, um ein erstes Additionsergebnis zu erzeugen, das eine erste Summe und einen ersten Übertrag umfasst, bis ein erstes Steuersignal empfangen wird, wobei das Steuersignal in Reaktion darauf ausgegeben wird, dass eine Menge an Daten empfangen wird, die einer vorgegebenen Länge entspricht;
b) Ausgeben der ersten Summe und des ersten Übertrags, die aus dem ersten Additionsergebnis ermittelt werden, wenn das Steuersignal empfangen wird; und
c) Addieren der ersten Summe und des ersten Übertrags aus dem Additionsergebnis, um das erste Additionsergebnis in eine Prüfsumme umzuwandeln.

## Revendications

1. Dispositif de génération de total de contrôle, comportant :
une unité de commande (220) laquelle, en réponse à des informations sur une longueur prédéterminée, délivre en sortie un signal de commande lorsqu'une quantité de données correspondant à la longueur prédéterminée est reçue,
une unité d'addition (210) qui reçoit des données, exécute une addition sur les données reçues pour produire un premier résultat d'addition comportant un premier total et un premier report et, en réponse au signal de commande, délivre en sortie ledit premier total et ledit premier report à partir dudit premier résultat d'addition, et
une unité de conversion (230) qui convertit le premier total et le premier report en un total de contrôle en ajoutant le premier total au premier report.

2. Dispositif de génération de total de contrôle selon la revendication 1, dans lequel le total de contrôle a une valeur de 16 bits.

3. Dispositif de génération de total de contrôle selon la revendication 1, dans lequel l'unité d'addition (210) reçoit des données en unités de 32 bits et exécute une addition sur les données reçues.

4. Dispositif de génération de total de contrôle selon la revendication 1, dans lequel l'unité d'addition (210) reçoit des données en unités de 32 bits plus multiple de 16 bits et exécute une addition sur les données reçues.

5. Dispositif de génération de total de contrôle selon la revendication 1, dans lequel l'unité de conversion (230) divise le premier résultat d'addition en un premier total et un premier report, partitionne le premier total en segments de 16 bits, et ajoute les segments de 16 bits au premier report, obtenant ainsi un deuxième résultat d'addition.

6. Dispositif de génération de total de contrôle selon la revendication 5, dans lequel, lorsqu'un second report survient dans le deuxième résultat d'addition, l'unité de conversion exclut le second report du deuxième résultat d'addition pour produire un second total et ajoute le second report au second total, délivrant ainsi un deuxième résultat d'addition.

7. Dispositif de génération de total de contrôle selon la revendication 6, dans lequel l'unité de conversion (230) délivre en sortie une valeur de complément 1 du troisième résultat d'addition pour obtenir un total de contrôle de 16 bits.

8. Dispositif de génération de total de contrôle selon la revendication 1, dans lequel l'unité d'addition (210) comporte :
un additionneur (305) pour additionner les données reçues en unités de 32 bits, et
un additionneur de reports (310) pour additionner des reports générés dans l'additionneur (305).

9. Dispositif de génération de total de contrôle selon la revendication 1, dans lequel l'unité d'addition (210) comporte :
un additionneur (305) pour additionner les données reçues en unités de 32 bits plus multiple de 16 bits, et
un additionneur de reports (310) pour ajouter des reports générés dans l'additionneur (305).

10. Dispositif de génération de total de contrôle selon la revendication 1, dans lequel l'unité de conversion (230) comporte :
une unité d'addition de total partiel (315) pour exclure le premier report du premier résultat d'addition afin de former un premier total, partitionner le premier total en segments de 16 bits, additionner les segments de 16 bits, afin d'obtenir ainsi un résultat d'addition partiel comportant un total partiel,
un premier additionneur (320) pour ajouter le premier report au total partiel afin de produire un deuxième résultat d'addition comportant un second total et un second report,
un second additionneur (325) pour additionner le second total et le second report formant un troisième résultat d'addition, et
un calculateur de complément (330) pour délivrer en sortie une valeur de complément 1 du troisième résultat d'addition.

11. Procédé de génération d'un total de contrôle, le procédé comportant les étapes consistant à :
(a) additionner des données d'entrée jusqu'à ce qu'un signal de commande prédéterminé soit reçu pour produire un premier résultat d'addition comportant un premier total et un premier report, le signal de commande est délivré en sortie en réponse à une quantité de données correspondant à une longueur prédéterminée étant reçue,
(b) délivrer en sortie ledit premier total et ledit premier report obtenus à partir dudit premier résultat d'addition, résultant de l'étape (a), lorsque le signal de commande est reçu, et
(c) additionner ledit premier total et ledit premier report depuis ledit premier résultat d'addition pour convertir ledit premier résultat d'addition en un total de contrôle.

12. Procédé de génération d'un total de contrôle selon la revendication 11, dans lequel le total de contrôle a une valeur de 16 bits.

13. Procédé de génération d'un total de contrôle selon la revendication 11, dans lequel le signal de commande est délivré en sortie lorsqu'une quantité de données correspondant aux informations de longueur de données d'entrée est reçue.

14. Procédé de génération d'un total de contrôle selon la revendication 11, dans lequel à l'étape (a) des données sont reçues en unités de 32 bits et une addition est exécutée sur les données reçues.

15. Procédé de génération d'un total de contrôle selon la revendication 11, dans lequel, à l'étape (a), des données sont reçues en unités de 32 bits plus multiple de 16 bits et une addition est exécutée sur les données reçues.

16. Procédé de génération d'un total de contrôle selon la revendication 11, dans lequel, à l'étape (c), le premier résultat d'addition est divisé en un premier total et un premier report, le premier total est partitionné en segments de 16 bits, et les segments de 16 bits sont additionnés au premier report, un deuxième résultat d'addition ainsi étant obtenu.

17. Procédé de génération d'un total de contrôle selon la revendication 16, dans lequel, lorsqu'un second report apparaît dans le deuxième résultat d'addition, à l'étape (c), le second report est exclu du deuxième résultat d'addition pour former un second total et, ensuite, le second report est ajouté au second total, un troisième résultat d'addition étant ainsi délivré en sortie.

18. Procédé de génération d'un total de contrôle selon la revendication 17, dans lequel, à l'étape (c), une valeur de complément 1 du troisième résultat d'addition est délivrée en sortie en tant que total de contrôle de 16 bits.

19. Procédé de génération d'un total de contrôle selon la revendication 11, dans lequel l'étape (b) comporte en outre les étapes consistant à :
(b1) additionner les données reçues en unités de 32 bits, et
(b2) additionner des reports générés à l'étape (b1).

20. Procédé de génération d'un total de contrôle selon la revendication 11, dans lequel l'étape (b) comporte en outre les étapes consistant à :
(b1) additionner les données reçues en unités de 32 bits plus multiple de 16 bits, et
(b2) additionner des reports générés à l'étape (b1).

21. Procédé de génération d'un total de contrôle selon la revendication 11, dans lequel l'étape (c) comporte en outre les étapes consistant à :
(c1) exclure un premier report des premiers résultats d'addition formant le premier total, partitionner le premier total en segments de 16 bits, additionner les segments de 16 bits, de manière à obtenir un résultat d'addition partiel comportant un total partiel,
(c2) additionner le premier report au total partiel, de manière à produire un deuxième résultat d'addition comportant un second total et un second report,
(c3) additionner le second total de l'étape (c2) et le second report apparaissant dans le deuxième résultat d'addition, de manière à produire un troisième résultat d'addition, et
(c4) délivrer en sortie une valeur de complément 1 du troisième résultat d'addition de l'étape (c3).

22. Support de mémorisation lisible par ordinateur mémorisant des instructions exécutables par ordinateur, dans lequel lesdites instructions, lorsqu'elles sont exécutées sur un ordinateur, mettent en oeuvre un procédé de génération d'un total de contrôle, le procédé comportant les étapes consistant à :
(a) additionner des données d'entrée jusqu'à ce qu'un signal de commande prédéterminé soit reçu pour produire un premier résultat d'addition comportant un premier total et un premier report, le signal de commande délivré en sortie en réponse à une quantité de données correspondant à une longueur prédéterminée étant reçu,
(b) délivrer en sortie ledit premier total et ledit premier report obtenus à partir dudit premier résultat d'addition lorsque le signal de commande est reçu, et
(c) additionner ledit premier total et ledit premier report à partir du résultat d'addition pour convertir ledit premier résultat d'addition en un total de contrôle.
